# EUROPEAN PATENT SPECIFICATION

(11) **EP 1 909 391 B1**
(45) Date of publication and mention of the grant of the patent: **26.08.2009**
(21) Application number: 07253951.3
(22) Date of filing: 05.10.2007
(51) Int. Cl.: H03H 9/00

(54) **Crystall oscillator**
Kristalloszillator
Oscillateur cristallin

(30) Priority: 05.10.2006 JP 2006274511
(43) Date of publication of application: 09.04.2008
(73) Proprietor: Nihon Dempa Kogyo Co., Ltd., Shibuya-ku Tokyo (JP)
(72) Inventor: Harada, Masakazu c/o Nihon Dempa Kogyo Co., Ltd., Tokyo (JP); Takahashi, Hidesada c/o Furukawa NDK Co., Ltd, Furukawa Oosaki-city, Miyagi (JP)
(74) Representative: Marshall, Caroline

(56) References cited:
- GB-A- 2 021 311
- JP-A- 2000 354 947
- LEE P C Y ET AL: "Piezoelectrically forced thickness-shear and flexural vibrations of contoured quartz resonators" FREQUENCY CONTROL SYMPOSIUM, 1995. 49TH., PROCEEDINGS OF THE 1995 IEEE INTERNATIONAL SAN FRANCISCO, CA, USA 31 MAY-2 JUNE 1995, NEW YORK, NY, USA,IEEE, US, 31 May 1995 (1995-05-31), pages 705-715, XP010155240 ISBN: 0-7803-2500-1
- SMAGIN A G: "Irreversible frequency variations in time of precision quartz crystal units" FREQUENCY CONTROL SYMPOSIUM, 1994. 48TH., PROCEEDINGS OF THE 1994 IEEE INTERNATIONAL BOSTON, MA, USA 1-3 JUNE 1994, NEW YORK, NY, USA,IEEE, 1 June 1994 (1994-06-01), pages 541-543, XP010137822 ISBN: 0-7803-1945-1

## Description

### FIELD OF THE INVENTION

The present invention relates to an AT-cut crystal oscillator and, in particular, to a crystal oscillator for the 4-MHz frequency band that has a crystal piece with external plan-view dimensions that have been greatly reduced to substantially half those of prior-art examples.

### BACKGROUND OF THE INVENTION

An AT-cut crystal oscillator is known as a representative example of a thickness-shear resonator, which is widely employed as a frequency reference source in various kinds of electronic equipment for the frequency bands of roughly 1 to 40 MHz (fundamental harmonics) . During the recent progress towards the miniaturization of crystal oscillators in frequency bands of 5 MHz upward, a problem has occurred in that it is still necessary to employ means such as beveling of the crystal piece of a crystal oscillator (AT cut) such as one for the 4-MHz band, making it difficult to prevent an increase in size thereof.

An example of such an oscillator is disclosed in the document "Piezoelectrically forced thickness-shear and flexural vibrations of contoured quartz resonators" FREQUENCY CONTROL SYMPOSIUM, 1995. 49TH., PROCEEDINGS OF THE 1995 IEEE INTERNATIONAL SAN FRANCISCO, CA, USA 31 MAY-2 JUNE 1995, NEW YORK, NY, USA,IEEE, US, 31 May 1995 (1995-05-31), pages 705-715, XP010155240 ISBN: 0-7803-2500-1.

The external dimensions in plan view of a crystal oscillator consisting of a crystal piece 1 housed in a sealed container are becoming smaller, to defact standards of: 12 x 5.5 mm, 8.0 x 4.5 mm, 5.0 x 3.2 mm, 3.2 x 2.5 mm, 2.5 x 2.0 mm, and 2.0 x 1.0 mm. Of these, while the external plan-view dimensions for frequencies above the 5-MHz band are becoming smaller at 8.0 x 4.50 mm or less, the minimum dimensions for the 4-MHz band are still 12 x 5.5 mm and there are demands for a transition to 8.0 x 4.5 mm as the next step.

The miniaturization of such a crystal oscillator depends on the external dimensions of the crystal piece that is housed within the sealed container thereof. Since the thickness of the crystal piece decreases with increasing resonant frequency and thus the external plan-view dimensions thereof become relatively larger, the external plan-view dimensions of the crystal piece can be made smaller for higher frequencies. In contrast thereto, the thickness of the crystal piece increases as the frequency decreases, the external plan-view dimensions of the crystal piece become relatively smaller, and thus the external plan-view dimensions of the crystal piece become larger at lower frequencies.

If the external plan-view dimensions of the crystal oscillator are the previously mentioned 12 x 5.5 mm for the frequency band of 4 MHz, by way of example, the external plan-view dimensions of the crystal piece are approximately 8.24 x 1.72 mm. However, to take the external plan-view dimensions of the crystal oscillator to the next step of 8.0 x 4.5 mm, it will be necessary to make the external plan-view dimensions of the crystal piece 1 approximately 5.25 x 1.80 mm. It would therefore be required to halve the current dimensions of the crystal piece. Note that in order to prevent confusion between the external plan-view dimensions of the crystal oscillator and of the crystal piece in the description below, a crystal oscillator, that has external plan-view dimensions of 12 x 5.5 mm is called a "1255-type oscillator" and a crystal oscillator measuring 8.0×9.5 mm is called a "8045-type oscillator".

### DESCRIPTION OF RELATED ART

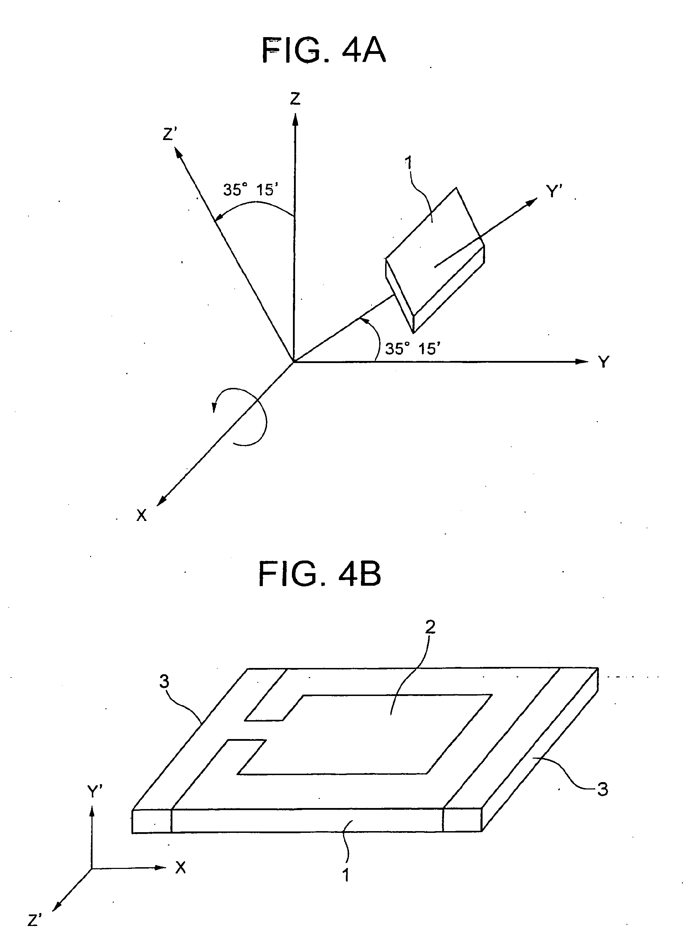

A representative prior-art example of a crystal oscillator is illustrated in FIG. 4, where FIG. 4A shows the orientations of the cutting planes thereof and FIG. 4B is a perspective view of a crystal piece.

In this case, the crystal oscillator houses an AT-cut crystal piece 1 within a sealed container for surface mounting use (not shown in the figures). The sealed container is formed of a main container body, with the crystal piece 1 affixed to a concave inner base surface thereof, and a cover in the shape of a flat plate. With the AT cut, the principal surface of the crystal piece 1 that intersects the Y-axis of the crystal axes (XYZ) is rotated through 35 degrees 15 minutes from the Y-axis to the Z-axis direction, using the X-axis as a rotational axis. Assume that the thickness of the crystal piece 1 is the Y'-axis direction and the external dimensions thereof in plan view is rectangular (narrow card shape). In this case, assume also that the length of the crystal piece 1 lies along the X-axis direction and the width thereof lies along the Z'-axis direction.

An excitation electrode 2 that induces thickness-shear resonance is formed on each principal surface of the crystal piece 1, the crystal piece 1 is held in a sealed container, and an extracting electrode 3 is lead out from each end portion of the crystal piece 1, by way of example. Thickness-shear resonance is a resonance mode in which displacement is in mutually opposite directions in the X-axis direction between the two principal surfaces of the crystal piece 1, where the resonance energy is transmitted in the Z' -axis direction. The resonant frequency depends (inversely) on the thickness in the Y' -axis direction, so that the resonant frequency increases as the thickness decreases. For example, assuming a frequency constant of 1670, deriving the resonant frequency by dividing this by the thickness of the crystal piece 1 gives a value of approximately 1.67 mm for a frequency of 1 MHz.

If the surface area of each excitation electrode 2 is assumed to be constant in such a case, any increase in the external plan-view dimensions of the crystal piece 1 have little effect when the outer periphery is supported, by way of example, enabling favorable retention of the resonance characteristics and also simplifying the design. For that reason, since the thickness of the crystal piece 1 decreases as the resonant frequency increases so that the external plan-view dimensions become relatively large, the external plan-view dimensions can be made small for high frequencies above the 5-MHz band (thicknesses of less than approximately 0.34 mm), as previously described.

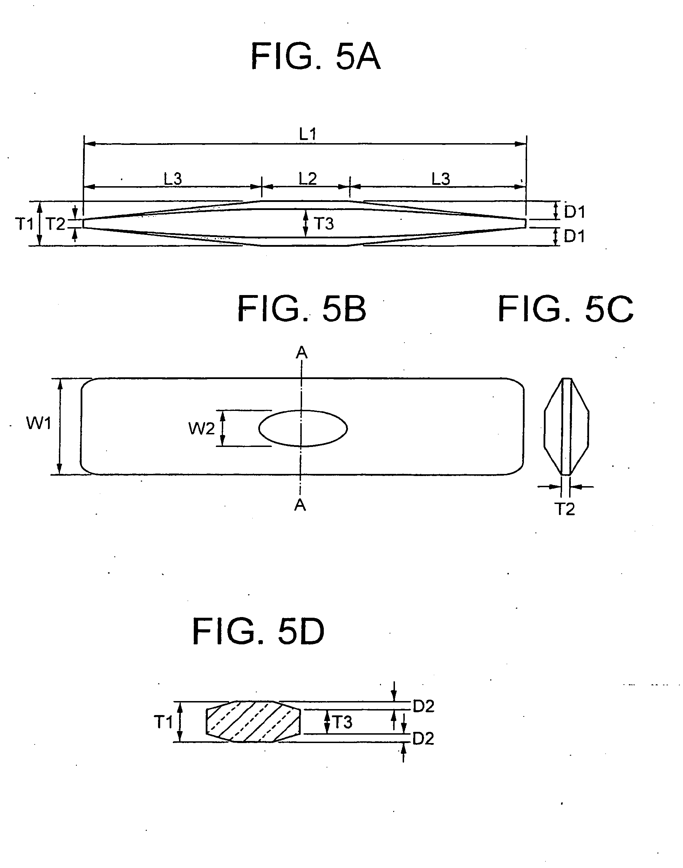

In contrast thereto, since the thickness of the crystal piece 1 has to be increased for frequencies below about the 4-MHz band (a thickness of over 0.42 mm), the external plan-view dimensions of the crystal piece 1 have to be increased dramatically to ensure a surface area ratio with respect to thickness that is the same as that for the 5-MHz band upward. For that reason, inclined portions (called "beveling") are usually provided on the outer peripheries of the two principal surfaces of the crystal piece 1 for frequencies below about the 4-MHz band, as shown in FIG. 5. It should be noted that means such as beveling might be necessary for reducing the external plan-view dimensions of the crystal piece 1 even with frequency bands of 5 MHz upwards.

Note that FIG. 5A is a front view of the crystal piece in the long-edge direction, FIG. 5B is a plan view thereof, FIG. 5C is a side view in the short-edge direction thereof, and FIG. 5D is a section taken along the line A-A of FIG. 5B. It should also be noted that the plan view in FIG. 5 is a 15-times enlarged view of the actual dimensions, and the thickness dimension in the front and side views are shown larger for convenience. In practice, the width in plan view would be about 1/4 of that shown. In addition, the two side surfaces in the widthwise direction (Z'-plane) are inclined at 5 degrees to prevent coupling with contour oscillations in the transmission direction (Z' direction). Note that this inclination of 5 degrees is omitted from the figures.

These inclined surfaces (bevel portions) of the two principal surfaces are provided on each of the two end sides in the long-edge and short-edge directions of the crystal piece 1, and are symmetrical about the center lines thereof. It should be noted that if the two side surfaces in the widthwise direction are inclined at θ degrees, the inclined portions between the two principal surfaces will be opposite directions. In addition, each of the two end sides has an end surface that has a certain thickness. The beveling in this case is done by placing a large number of the crystal pieces 1 into a hollow container (grinding container) that is formed as a cylinder or sphere having a curved inner diameter, to create several such bevel portions at the same time.

Inclined bevel portions are thereby formed on the outer periphery of each crystal piece 1, so that the resonance energy is trapped in the central region (flatter portion) of each crystal piece. Since leakage of resonance energy is therefore prevented, even when the outer periphery of the crystal piece is restrained, the external plan-view dimensions can be reduced. Note that if the resonant frequency is high, such as at frequency bands of 5 MHz upward, the thickness is reduced to its previous value, so the effect of the beveling is small and a flat plate-shaped piece would generally be used.

More specifically, the external plan-view dimensions of the crystal piece 1 can be reduced to the previously mentioned 8.24 mm (length L1) x 1.72 mm (width W1) and a crystal oscillator can be obtained by sealing the crystal piece 1 into a sealed container for a 1255-type oscillator. Note that the dimension of the crystal piece 1 in the widthwise direction (Z'-axis direction) is much smaller at 1.72 mm than the 8. 24 mmdimension of the crystal oscillator in the same direction, but the superimposing of spurious contour oscillations onto the main oscillation (thickness-shear resonance) can be prevented.

Of course, if spurious resonances do not occur, the crystal piece 1 can be made larger so that the resonance region (flatter portion) is also increased and the CI is further reduced, so that the external plan-view directions could be increased further. It should be noted that the X-axis direction is also the displacement direction for thickness-shear resonance. Since the X-axis is set to be the lengthwise direction in this case, the CI is controlled by the length in the X-axis direction. In addition, since more of the crystal pieces 1 can be cut from a single crystal wafer as the width W1 decreases, a smaller width is preferable provided the characteristics remain about the same. The long edge L1 of the crystal piece 1 is such that the surface area of the flat surface is increased, but not by enough to touch the inner walis of the main container body.

In this case, the flatter-portion length ratio L2/L1 in the lengthwise (X-axis) direction of the two principal surfaces of the crystal piece 1, excluding the inclined portions thereof, is approximately 0.185, and the flatter-portion width ratio W2/W1 in the widthwise (Z'-axis) direction thereof is 0.30. In addition, assume that the thickness T1 of the crystal piece 1 is approximately 0.42 mm because the frequency band is 4 MHz, and the long-edge bevel depth ratio D1/T1 of the two end portions in the lengthwise direction is 0.26. Assume that the short-edge bevel depth ratio D2 /T1 in the short-edge direction is 0.06.

Note that each of the bevel depths D1 and D2 is the depth at the center of the corresponding short edge (width) and long edge (length). In this case, on the long edge formed by the two end sides of the short-edge direction in particular, the two end portions of each long edge and the two end portions of each short edge are T2, which increases gradually towards the center of the outer periphery of the long edge so that the end surface thickness increases to a maximum of T3 at the central portion thereof. In this case, although there is a similar trend on the two end sides (short edges) in the long-edge direction, the length in the widthwise direction is so short that there is a substantially uniform end surface thickness.

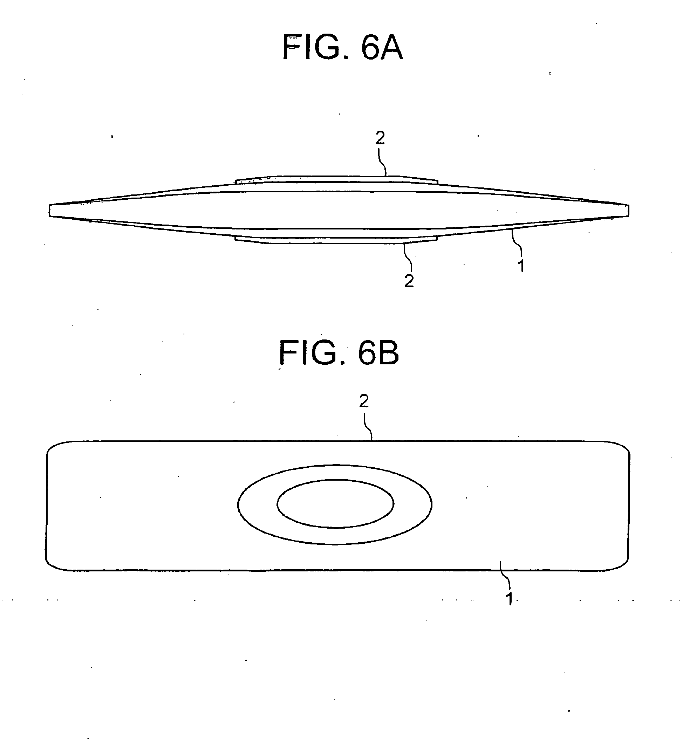

In this case, the excitation electrodes 2 of the crystal piece 1 are formed not only over the flatter portions of the corresponding principal surfaces but also extending over the inclined portions thereof, as shown in FIG. 6. This enables the excitation of the entire surface of the flatter portions, increasing the utilization efficiency. Note that although the flatter portions and inclined portions are depicted by straight lines for the sake of convenience in FIGS. 5 and 6, strictly speaking each surface is a curved surface because the crystal piece 1 is ground within the curved surfaces in the hollow container, as previously described. In this case, the curves from the two principal surfaces of the crystal piece 1 are curved surfaces that increase continuously, and the two end portions in each of the long-edge and short-edge directions are also arc-shaped.

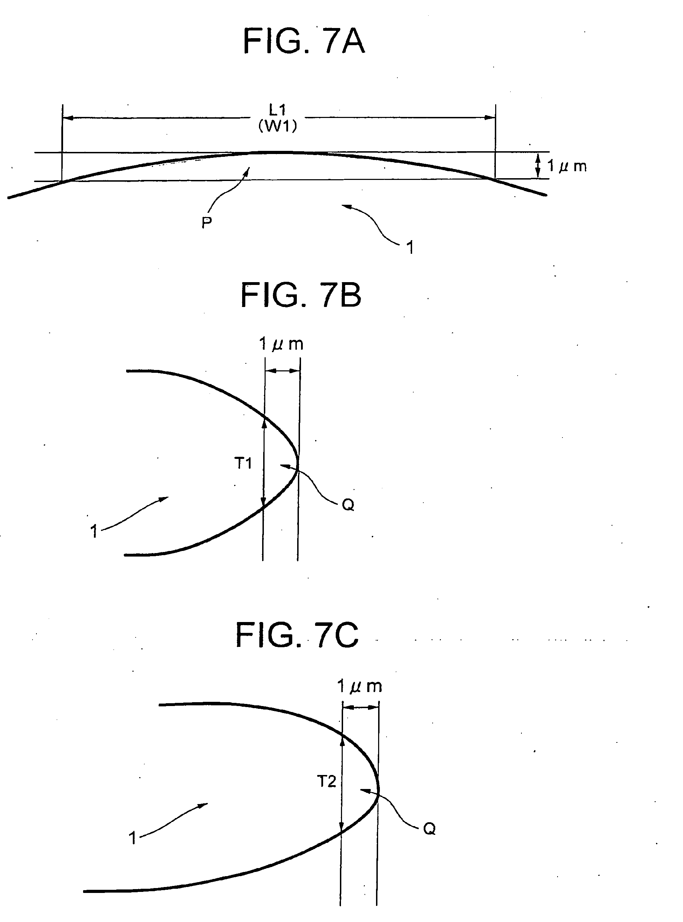

This means that the flatter portion P of each principal surface of the crystal piece 1 in this case indicates a region within 1 µm from the portion of maximum thickness at the center of the crystal piece 1, and the length L1 and width W1 of the flatter portion P are dimensions between the two ends thereof in the corresponding directions, as shown in FIG. 7A. Each of two end portions Q of the crystal piece 1 in the lengthwise direction indicates a region within 1 µm from an arc-shaped leading edge, and the thickness (end surface thickness) of each of the two end portions is the dimension between the upper and lower ends within 1 µm from the leading edge (see FIG. 7B). This means that the long-edge bevel depth D1 at each of the two end portions of the crystal piece 1 is the difference between the surface 1 µm inward from the leading edges of the two end portions in the long-edge direction and the maximum thickness portion of the crystal piece 1.

Since each of the two end portions Q in the widthwise direction of the crystal piece 1 is inclined at 5 degrees in this case, the curvature of the upper surface side (or the lower surface side) is larger and that of the lower surface side (upper surface side) is smaller. In this case too, the dimensions of the upper and lower edges 1 µm inward from the arc-shaped leading edge is the thickness (end surface thickness) T3 of the two end portions (see FIG. 7C). Strictly speaking, the short-edge bevel depth D2 in this case differs between the two principal surfaces, but this discrepancy can be ignored here.

### PROBLEMS WITH PRIOR ART

However, a 4-MHz band crystal oscillator of the above-described configuration can be reduced to a level that permits mass production of a crystal piece 1 with external plan-view dimensions of 8.24 x 1.72 mm, depending on the beveling conditions in particular, but it is difficult to cope with the miniaturization of crystal oscillators for higher frequency bands (such as external plan-view dimensions of the sealed container of 8.0 x 4.5 mm).

In other words, beveling is necessary for a 4-MHz band crystal oscillator, as previously described, and since strict beveling conditions are required for maintaining the resonance characteristics, particularly the crystal impedance (hereinafter abbreviated to "CI"), the external plan-view dimensions of the crystal piece 1 are limited to 8.24 x 1.72 mm, which limits the size of the crystal oscillator to the previously mentioned 12 x 5.5 mm.

Note that when it comes to implementing such miniaturization, there has been no disclosure or even suggestion of beveling conditions that would enable a further major advance in miniaturization, such as a flatter-portion length ratio L2/L1, flatter-portion width ratio W2/W1, and bevel depth ratios D1/T1 and D2/T1 that would be objectives when implementing mass production using hollow containers in particular, as far as the present inventors are aware, even though success has been achieved at the research or experimentation level.

### OBJECTIVE OF THE INVENTION

An objective of the present invention is to provide a crystal oscillator in which the crystal piece has an inclined portion (beveling) around the outer periphery and a greatly reduced surface area in plan view.

### SUMMARY OF THE INVENTION

The present invention relates to a crystal oscillator formed of an AT-cut crystal piece having a rectangular shape in plan view with long edges and short edges; where a large number of the crystal pieces are placed within a hollow container having a curved inner periphery and the crystal piece is ground along the inner periphery of the hollow container as the hollow container is rotated; an inclined portion is provided over the entire outer periphery of each of two principal surface sides of the crystal piece; and a central region of the crystal piece is a flatter portion; wherein the flatter-portion length ratio L2/L1 of the length L1 in the long-edge direction of the crystal piece and the length L2 of the flatter portion is between 0.24 and 0.33, and also the long-edge bevel depth ratio D1/T1 of the thickness T1 of the crystal piece and the depth D1 from each of the two principal surfaces at the center of the outer periphery of the inclined portion at each of two end portions in the long-edge direction is between 0.30 and 0.38.

### EFFECTS OF THE INVENTION

The above-describe configuration ensures that the ratio L2/L1 of the length L2 of the flatter portion of the crystal piece 1 to the overall length L1 thereof is 0.24 to 0.33, which is an increase of approximately 50% (between 29.7% and 78.4%) over the 0.185 of the prior-art example. Therefore, if the short edges (width) of the crystal piece are made to be substantially the same as in the prior-art example, the surface area of the flatter portion (resonance region) can also be increased by 50%, thereby enabling a reduction in the CI. Note that since the thickness of the flatter portion of the crystal piece is tuned for the main resonance (4 MHz, by way of example), the resonance region increases at the main resonance as the surface area of the flatter portion increases.

In addition, the long-edge bevel depth ratio D1/T1 at the two end sides in the long-end direction with respect to the T1 of crystal piece is set to 0.30 to 0.38, which is greater than that of the prior-art example. This increases the effect of trapping the energy in the flatter portion when the flatter-portion length ratio L2/L1 is set to 0.24 to 0.33. The effect of trapping the energy is increased by making the depth of this inclined portion greater than in the prior art in this case. It should be noted, however, that if the long-edge bevel depth ratio D1/T1 exceeds 0.34, the trapping effect could be reduced by causes such as reflections at the end surfaces.

If the long edges (lengthwise direction) of the crystal piece is made the X-axis direction in such a case, the direction of displacement of thickness-shear resonance is increased so that the CI can basically be reduced in comparison with the case in which the Z' -axis direction is made the lengthwise direction. It should be noted that this effect can be applied even when the Z' -axis is made the lengthwise direction, because the length of the flatter portion (resonance region) is increased.

### Embodiment

In accordance with the present invention, the flatter-portion width ratio W2/W1 of the width W1 of the crystal piece and the width W2 of the flatter portion is set to between 0.25 and 0.55, and the short-edge bevel depth ratio D2/T1 of the thickness T1 of the crystal piece and depth D2 at the center of the outer periphery of the inclined portion at each of the two end portions in the short-edge direction is set to between 0.08 and 0.14.

This sets the flatter-portion width ratio W2/W1 with respect to the crystal piece 1 in the short-edge direction to between 0.25 and 0.55, which is about the same or greater than the 0.30 of the prior-art example. Together with the setting of the flatter-portion length ratio L2/L1 to between 0.24 and 0.33, this reliably increases the surface area of the flatter portion. In addition, the short-edge bevel depth ratio D2/T1 with respect to thickness in the short-edge direction is set to between 0.08 and 0.14, which is an increased of approximately 2 to 2.5 times over the 0.06 of the prior-art example. The trapping effect is therefore increased and the CI reduced in the widthwise direction as well.

The present invention also ensures that the extracting electrode formed on each of the principal surfaces of the crystal piece extends from the corresponding flatter portion over the inclined portion. This enables excitation over with entire region of the flatter portion that forms the resonance region, without leakage, thus contributing to an increase in the utilization efficiency and a lowering of the CI.

Furthermore, the present invention ensures that crystal piece is aligned with the X-axis direction of the AT-cut crystal axes (XY' Z') along the long edges and the Z' -axis along the short edges. This enables the displacement direction of the thickness-shear resonance to lie along the long edges (lengthwise direction), thus simplifying the resonance and reducing the CI.

In this case, the Z'-plane of the crystal piece in accordance with the present invention, which lies along the lengthwise direction thereof intersecting the Z'-axis, is inclined at an angle θ degrees from the Y' -axis direction toward the Z' -axis direction. This prevents coupling with contour oscillations of the resonance energy that is transmitted in the Z' direction, preventing any increase in CI.

The angle θ degrees is set to 5 degrees in accordance with the present invention. This makes the angle of inclination obvious, enabling reliable suppression of any increase in CI.

The present invention also states that the hollow container is spherical; and the thickness of each of the long-edge end surfaces that form two end sides in the short-edge direction of the crystal piece is such that the two corner portions of each of the short edges define the thickness of two corner portion of each of the long-edge end surfaces, which increases gradually towards the center of the outer periphery of the long edge. This is because when a crystal piece of a rectangular shape is inserted into a sphere shape of the container, the four corner portions of each of the principal surfaces come into contact therewith first and are sequentially ground thereby, so that the center of the end surface of each principal surface along the long edges are the last to come into contact therewith.

The present invention further sets the frequency band of the crystal piece to 4 MHz with external plan-view dimensions thereof of 5.25 x 1.80 mm. This enables anyone to supply various industrial fields with a 8045-type oscillator for the 4-MHz frequency band that will operate successfully over many years, which would be extremely advantageous from the business point of view.

Still further, the present invention states that the flatter portion is a region within 1 µm from the maximum thickness of the crystal piece; and each of the depths D1 and D2 is the difference between the surface 1 µm inward from the leading edges of the two end portions in the long-edge direction and the maximum thickness portion thereof. This clarifies the depths of the flatter portion and the two end portions in accordance with the present invention.

### Brief Description of the Drawings

FIG. 1 is illustrative of an embodiment of the crystal oscillator of the present invention, where FIG. 1A is a front view of the crystal piece in the long-edge direction, FIG. 1B is a plan view, and FIG. 1C is a side view in the short-edge direction;
FIG. 2 is illustrative of the action of this embodiment of the crystal oscillator of the present invention, where both FIGS. 2A and 2B are CI characteristics diagrams;
FIG. 3 is illustrative of the actions of the embodiment of the crystal oscillator of the present invention, where FIGS. 3A and 3B are CI characteristics diagrams thereof;
FIG. 4 is illustrative of a prior-art example of a crystal oscillator, where FIG. 4A shows the orientations of the cutting planes thereof and FIG. 4B is a perspective view of the crystal piece;
FIG. 5 is further illustrative of the prior-art example of the crystal oscillator, where FIG. 5A is a front view of the crystal piece, FIG. 5B is a plan view thereof, FIG. 5C is a side view thereof, and FIG. 5D is a section taken along the line A-A of FIG. 5B;
FIG. 6 is still further illustrative of the prior-art example of the crystal oscillator, where FIG. 6A is a front view thereof and FIG. 6B is a plan view; and
FIG. 7 is even further illustrative of the prior-art example of the crystal oscillator, where FIGS. 7A, 7B, and 7C are partial enlarged sections thereof.

### Detailed Description of Preferred Embodiments

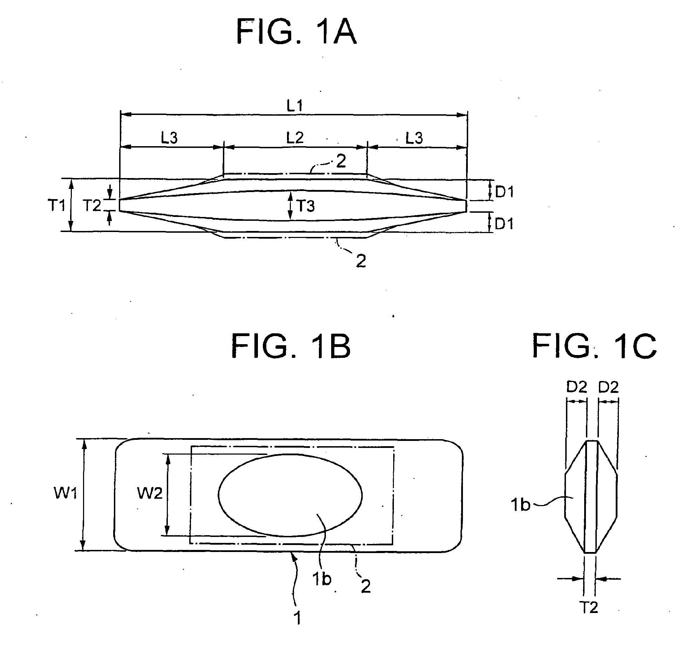

An embodiment of the crystal oscillator of the present invention is illustrated in FIG. 1, where FIG. 1A is a front view thereof in the long-edge direction, FIG. 1B is a plan view, and FIG. 1C is a side view in the short-edge direction. Note that portions that are the same as those of the prior-art example are denoted by the same reference numbers, and further description thereof is either abbreviated or omitted. In the plan view, the actual dimensions are shown enlarged 15 times, in a similar manner to the prior-art example.

The crystal oscillator of the present invention is formed of the AT-cut crystal piece 1 in a rectangular shape having long edges and short edges, as previously described. In this case too, the crystal piece 1 has a thickness T1 (0.42 mm) that establishes a frequency band of 4 MHz, and is provided with curved inclined portions (beveled surfaces) on the two end sides in both the long- and short-edge directions that form the entire outer periphery of each principal surface thereof so that the external dimensions thereof in plan view are beveled to 5.251 x 1.801 mm.

These beveled surfaces are formed by placing a large number of these narrow card shaped pieces in a spherical hollow container (not shown in the figures) together with a grinding agent, then gradually grinding the pieces starting from the four corner portions of the two principal surfaces by high-speed rotation of the hollow container. To prevent coupling with the contour oscillations of the resonance energy in this case, the crystal piece 1 is inserted into the spherical hollow container after the two side surfaces thereof that are in the Z' plane (long edges) are inclined at 5 degrees from the Y' -axis direction toward the Z'-axis direction. Note that this inclination is omitted from FIG. 1C.

The front and side views in the long-edge and short-edge directions of the crystal piece 1 that has been ground in this manner are such that inclined portions (beveled surfaces), which have end surfaces and which extend in all directions from a flatter portion in the central region of each principal surface, are formed in substantially the same way as in the configuration described above, where the curves from the central portion of each of the principal surfaces are curved surfaces that increase continuously. The long-edge end surfaces (the end surfaces of each long edge) are such that the thickness at corner portions of each short edge becomes gradually thicker towards the central portion thereof, to reach a maximum thickness T3 at that central portion. Since the width in the short-edge direction is so narrow, the short-edge end surfaces are of substantially uniform thickness.

The external plan-view dimensions (plan view) of the crystal piece 1 are such that the shape thereof is rectangular, with four corner portions la that are of an arc-shape which is larger than that of the prior art, and having an elliptical flatter portion 1b in the central region thereof. In this case, the flatter portion 1b is essentially of a shape that is close to circular, but it becomes an elliptical shape by the increase in the length of the long edges of the crystal piece 1 in comparison to the short edges. Note that the flatter portion 1b is a region within 1 µm from the maximum thickness T3 of the central portion, and each of the two end portions is a region within 1 µm from the arc-shaped leading edge thereof, as previously described.

The excitation electrode 2 is formed on each of the principal surfaces of the crystal piece 1 (see FIG. 4B), a previously described, and the two end portions from which the extracting electrodes 3 extend are affixed by an electrically conductive adhesive to the inner base surface of the main container (not shown in the figures). The crystal piece 1 is then sealed with a cover to form a crystal oscillator for surface mounting, by way of example.

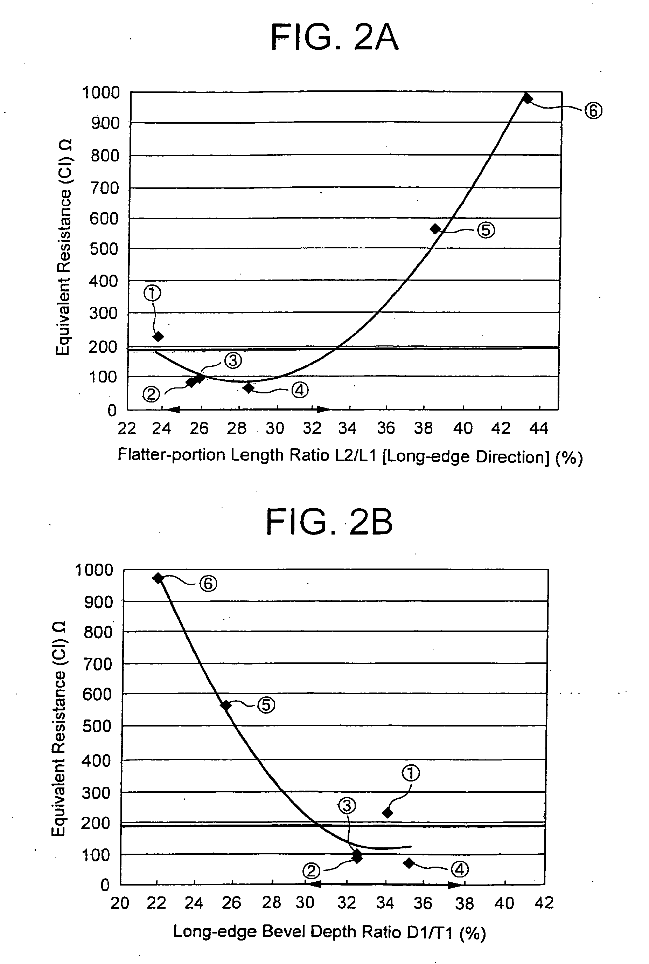

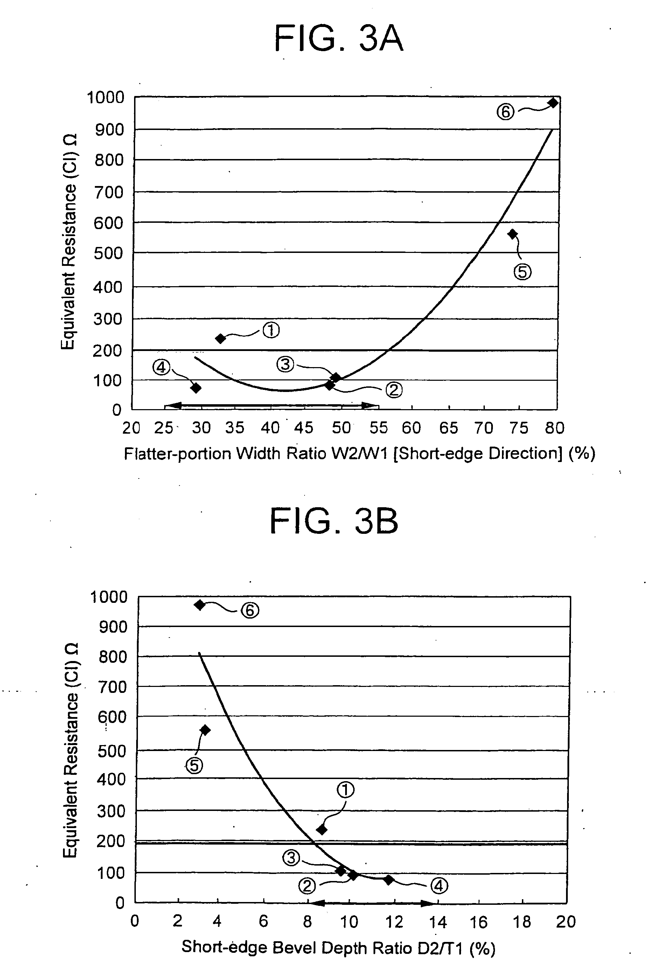

CI characteristics diagrams of crystal oscillators using such crystal pieces are shown in FIGS. 2 and 3. Note that FIG. 2A is a CI characteristics diagram for the flatter-portion length ratio L2/L1 of the length L1 of the crystal piece 1 and the length L2 of the flatter portion, and FIG. 2B is a CI characteristics diagram for the long-edge bevel depth ratio D1/T1 of the thickness T1 of the crystal piece 1 and the bevel depth D1 of each of the two end portions in the lengthwise direction.

Similarly, FIG. 3A is a CI characteristics diagram for the flatter-portion width ratio W2/W1 of the width W1 of the crystal piece 1 and the width W2 of the flatter portion, and FIG. 3B is a CI characteristics diagram for the short-edge bevel depth ratio D2/T1 of the thickness T1 of the crystal piece 1 and the bevel depth D2 of each of the two end portions in the widthwise direction.

Six different crystal pieces 1 with a resonant frequency of 4 MHz were formed by varying the grinding conditions of the crystal pieces 1 thereof. These graphs are the results of measuring the flatter-portion length ratio L2/L1, the long-edge bevel depth ratio D2/T1, the flatter-portion width ratio W2/W1, and the short-edge bevel depth ratio D2/T1 of each of these six crystal pieces 1, then measuring the CI characteristics of each crystal oscillator fabricated therewith. Note that the six data points (squares) in these graphs are actual measured values and the curves are quadratic approximation curves.

To summarize, six different crystal pieces having external plan-view dimensions of 5.25 x 1.80 mm and a resonant frequency of 4 MHz were formed by varying the grinding conditions such as the inner diameter of the grinding container (hollow container or sphere shape container), the rotational speed, the grinding time, and the grinding agent. The CI characteristics were then obtained for each ratio L2/L1, D1/T1, N2/W1, and D2/T1. In FIGS. 2A, 2B, 3A, and 3B, the six different crystal pieces are denoted by reference numbers 1 to 6, where the same reference number denotes the same crystal piece in all the graphs. Note that the dimensions in the lengthwise direction and widthwise direction are both reduced by grinding by approximately 0.001 mm.

As is clear from these figures, each CI characteristic (quadratic approximation curve) is a parabola that depends on the flatter-portion length ratio L2/L1, the long-edge bevel depth ratio D1/T1, the flatter-portion width ratio W2/W1, and the short-edge bevel depth ratio D2/T1.

Paying attention first of all to the long-edge direction of each crystal piece 1, the CI characteristic for the flatter-portion length ratio L2/L1 (seeFIG. 2A) forms a parabola with a minimum at approximately 100 Ω (the actual measured value was 70 Ω) at an L2/L1 ratio of approximately 0.28. Since the resonance displacement region also increases as the length of the flatter portion (in the X-axis direction) increases, thickness-shear resonance can be achieved simply. If the length of the flatter portion is increased beyond the minimum value of 100 Ω, the CI thereof will deteriorate (tend to increase) due to end surface reflections of the resonance energy.

The CI characteristic for the long-edge bevel depth ratio D1/T1 (see FIG. 2B) exhibits a minimum value of 100 Ω (the actual measured value was 70 Ω) when the D1/T1 ratio exceeds 0.34 (the actual measured value was 0.35), then the CI tends to increase beyond that point. This shows that the end surface reflections are prevented and the CI is low when the bevel depth D1 is made large, but the CI tends to increase when that minimum value is exceeded because the length of the flatter portion is substantially shortened thereby. Note that since the grinding is done in a spherical hollow container, the maximum value of the long-edge bevel depth ratio D1/T1 (0.35 in this case) remains unchanged after that maximum is met.

The description now turns to the short-edge direction of the crystal piece 1, where the CI characteristic for the flatter-portion width ratio W2/W1 (see FIG. 3A) exhibits a minimum value of 70 Ω (the actual measured value was 70 Ω) when the W2/W1 ratio exceeds approximately 0.42 (the actual measured value was 0.29), then the CI shows an upward trend beyond that. In this case, the resonance region (electrode surface area) in the widthwise direction increases and the CI decreases, but the CI deteriorates after the minimum value is achieved, due to causes such as reflection of the resonance energy at the end surfaces.

Similarly, the CI characteristic for the short-edge bevel depth ratio D2/T1 (see FIG. 3B) exhibits a minimum value of 70 Ω (the actual measured value was 70 Ω) when the D2/T1 ratio is 0.12 (the actual measured value was 0.12), then the CI tends to increase beyond that point. This shows that the end surface reflections can be prevented and the CI is low when the bevel depth D2 is made large, but the CI tends to increase when that minimum value is exceeded because the length of the flatter portion is substantially shortened thereby, in a similar manner to that seen in the long-edge direction of the crystal piece 1. Note that since D2/T1 in the widthwise direction of the crystal piece 1 stays at 0.12 after reaching that maximum, the effect of inclining the side surface (Z' surfaces) by 5 degrees is maintained. Note also that each beveled portion is a curved surface, as described previously.

The description now turns to extracting a range of up to 200 Ω, which is the target for actual use, from the quadratic approximation curves in the CI characteristics for each ratio L2/L1, D1/T1, W2/W1, and D2/T1. In other words, the minimum value of 0.28 for the flatter-portion length ratio L2/L1 is within a range of 0.24 to 0.34 and the minimum value of 0.34 for the long-edge bevel depth ratio D1/T1 is within a range of 0.30 to 0.38. Similarly, the minimum value of 0.42 for the flatter-portion width ratio W2/W1 for short-edge bevel depth ratio D2/T1 is within a range of 0.25 to 0.55 and the minimum value of 0.12 is within a range of 0.8 to 0.14.

The various ratios that produce the minimum CI value of 70 Ω in this embodiment are compared with similar values of the prior-art example below.

| | This Embodiment | Prior-art |
|---|---|---|
| Thickness T1 of crystal piece | 0.420 mm | 0.420 mm |
| Length L1 | 5.250 mm | 8.240 mm |
| Width W1 | 1.800 mm | 1.720 mm |
| Dimensional ratio W1/L1 | 0.349 | 0.209 |
| Flat portion length ratio L2/L1 | 0.280 | 0.185 |
| Long edge bevel depth ratio D1/T1 | 0.350 | 0.260 |
| Flat portion width ratio W2/W1 | 0.290 | 0.300 |
| Short edge bevel depth ratio D2/T1 | 0.120 | 0.060 |

The description now turns to studies of the external plan-view dimensions and flatter portion of the crystal piece 1 which have shown that the width W1 of the crystal piece 1 of this embodiment is substantially the same as that of the prior-art (actually slightly larger), the length L1 thereof is slightly shorter, but the dimensional ratio W1/L1 is increased from 0.209 to 0.349. Similar studies have shown that both the long and short edges are generally shortened to the same degree (called "uniform shortening"), but in this case the dimensional ratio W1/L1 is increased so that the surface area of the plate is relatively larger than a case in which uniform shortening occurs.

The flatter-portion length ratio L2/L1 is set to 0.280, which is a 1.5-times increase (50% increase) over the 0.185 of the prior-art example. This makes the length L2 of the flatter portion relatively larger, even though the length L1 of the crystal piece 1 is shortened. Since the lengthwise direction (X-axis direction) of the crystal piece 1 is the displacement direction for thickness-shear resonance, therefore, resonance is simplified and the CI can be reduced.

In such a case, since the flatter-portion width W2 (0.522 mm, giving a W2/W1 ratio of 0.290) is substantially the same as that of the prior-art (0.516 mm, giving a W2/W1 ratio of 0.300), the surface area of the flatter portion that is the resonance region is relatively larger in comparison with a case in which the dimensions are shortened uniformly (see above). In short, since the flatter-portion width W2 of this embodiment is substantially the same, or even greater, than that of the prior-art, the surface area of the flatter portion is relatively larger. Thus the resonance energy trapped within the flatter portion that is the resonance region also increases and the CI decreases.

Next, comparisons of the inclined portions (beveled surfaces) of the crystal piece 1 show that the horizontal length L3 (1.890 mm) in the lengthwise direction of this embodiment is shorter than that of the prior-art (3.358 mm) and the depth ratio D1/T1 (0.350) thereof is greater than that of the prior-art (0.260), in other words, the beveled slope has become steeper which increases the energy trapping effect. Therefore, if the two end portions of the crystal piece 1 are restrained, by way of example, leakage of resonance energy from those end portions is prevented and the CI can be kept small.

In addition, the horizontal length W3 (0.639 mm) in the widthwise (short-edge) direction of this embodiment is substantially the same (but slightly larger) as that of the prior-art (0.602 mm) and the depth ratio D2/T1 (0.120) is larger than that of the prior-art (0.060). The effect of trapping resonance energy in the widthwise direction is therefore increased and the CI is kept low. Note that a lack of restraint on the two ends in the widthwise direction has no effect on the leakage of resonance energy due to the restraining of the inclined portions (beveled surfaces), but it is useful to also form the inclined portions (beveled surfaces) in the widthwise direction of the crystal piece 1, from the viewpoint of preventing phenomena such as standing waves due to end surface reflections, thus preventing the occurrence of spurious signals.

From this it is clear that this embodiment provides a minimum CI value of 70 Ω with a crystal piece 1 having external plan-view dimensions of 5.25.x 1.80 mm (4 MHz). In contrast thereto, if inclined portions are formed in the long-edge and short-edge directions at similar ratios to those of the prior-art example when the external plan-view dimensions of the crystal piece 1 are the same 5.25 x 1.80 mm as that of this embodiment, the CI value would be roughly 600 Ω which gives a completely different result in practice.

The external plan-view dimensions of the crystal piece 1 of the above-described embodiment were given above as 5.25 x 1.80 mm (for 4 MHz), but the present invention can also be applied substantially when the dimensions of the long and short edges are within ±5%, allowing for errors. For example, since the crystal piece 1 can be housed in a sealed container for a 8045-type oscillator (the inner dimensions of the container of 5.5 x 2.4 mm, and the outer dimensions thereof of 8.0 x 4.5 mm by way of example), the length of the crystal piece 1 can be increased to about 5.5 mm (an approximately 5% increase). In addition, the two end portions of the crystal piece 1 from which the extracting electrodes extend were described as being restrained, but it is also possible to employ a configuration in which the extracting electrodes extend from two sides of one end portion of the crystal piece and those two sides of the one end portion are restrained.

## Claims

1. A crystal oscillator formed of an AT-cut crystal piece having a rectangular shape in plan view with long edges and short edges; an inclined portion is provided over the entire outer periphery of each of two principal surface sides of said crystal pieces where said inclined portion is formed when a large number of said crystal pieces are placed within a hollow container having a curved inner periphery and said crystal piece is ground along the inner periphery of said hollow container as said hollow container is rotated; a central region of said crystal piece is a flatter portion; wherein the flatter portion length ratio L2/L1 of the length L1 in the long-edge direction of said crystal piece to the length L2 of said flatter portion is between 0.24 and 0.33, and also the long-edge bevel depth ratio D1/T1 of the thickness T1 of said crystal piece and the depth D1 from each of the two principal surfaces at the center of the outer periphery of said inclined portion at each of two end portions in said long-edge direction is between 0.30 and 0.38, and wherein the flatter-portion width ratio W2/W1 of the width W1 of said crystal piece in said short-edge direction and the width W2 of said flatter portion is between 0.25 and 0.55, and also the short-edge bevel depth ratio D2/T1 of the thickness T1 of said crystal piece and the depth D2 at the center of the outer periphery of said inclined portion at each of the two ends portions thereof in the short-edge direction is between 0.08 and 0.14.

2. The crystal oscillator according to claim 1, wherein an excitation electrode formed on each of the two principal surfaces of the crystal piece partially extends over said inclined portion from said flatter portion.

3. The crystal oscillator according to claim 1, wherein said crystal piece is an AT-cut piece, the X-axis direction of the crystal axes (XY'Z') thereof is along said long edges and said Z'-axis direction is along said short edges.

4. The crystal oscillator according to claim 3, wherein the Z'-plane of said crystal piece that forms side surfaces in the lengthwise direction that intersect said Z'-axis are inclined at an angle θ degrees from said Y'-axis in said Z'-axis direction.

5. The crystal oscillator according to claim 4, wherein said θ degrees is 5 degrees.

6. The crystal oscillator according to claim 1, wherein said hollow container is spherical shape; and the thickness of each of the long-edge end surfaces that form two end sides in the short-edge direction of said crystal piece is such that the two corner portions of each of said short edges define the thickness of two corner portion of each of said long-edge end surfaces, which increases gradually towards the center of the outer periphery of said long edge.

7. The crystal oscillator according to claim 1, wherein the frequency band of said crystal piece is the 4-MHz band and the external plan-view dimensions of said crystal piece are 5.25 x 1.80 mm.

8. The crystal oscillator according to claim 1, wherein said flatter portion is a region within 1 µm from the maximum thickness of said crystal piece; and each of said depths D1 and D2 is the difference between the surface 1 µm inward from the leading edges of the two end portions in the long-edge direction and the maximum thickness portion thereof.

## Patentansprüche

1. Kristalloszillator ausgebildet aus einem eines AT-CUT-Kristallstück, das in der Draufsicht eine rechteckige Gestalt mit langen Kanten und kurzen Kanten aufweist; wobei über den gesamten Außenumfang von jeder von zwei Hauptseitenflächen des Kristallstücks ein geneigter Teilbereich vorgesehen ist, wobei der geneigte Teilbereich ausgebildet wird, wenn eine große Anzahl der Kristallstücke in einen hohlen Behälter mit einem gekrümmten Innenumfang gegeben wird und das Kristallstück den Innenumfang des hohlen Behälters entlang schleift, während der hohle Behälter gedreht wird; wobei ein Zentralbereich des Kristallstücks ein flacherer Teilbereich ist; wobei das flacherer-Teilbereich-Längenverhältnis L2/L1 der Länge L1 in der Langkantenrichtung des Kristallstücks zu der Länge L2 des flacheren Teilbereichs zwischen 0,24 und 0,33 beträgt und zudem das Langkantenfasentiefenverhältnis D1/T1 der Dicke T1 des Kristallstücks und der, Tiefe D1 von jeder der zwei Hauptflächen am Mittelpunkt des äußeren Umfangs des geneigten Teilbereichs an jedem von zwei Endbereichen in der Langkantenrichtung zwischen 0,30 und 0,38 beträgt, und wobei das flacherer-Teilbereich-Breitenverhältnis W2/W1 der Breite W1 des Kristallstücks in der Kurzkantenrichtung und der Breite W2 des flacheren Teilbereichs zwischen 0,25 und 0,55 beträgt und zudem das Kurzkantenfasentiefenverhältnis D2/T1 der Dicke T1 des Kristallstücks und der Tiefe D2 an dem Mittelpunkt des äußeren Umfangs des geneigten Bereichs an jedem dessen Endbereiche in der Kurzkantenrichtung zwischen 0,08 und 0,14 beträgt.

2. Kristalloszillator nach Anspruch 1, wobei sich eine Anregungselektrode, die auf jeder der beiden Hauptflächen des Kristallstücks ausgebildet ist, von dem flacheren Teilbereich teilweise über den geneigten Teilbereich erstreckt.

3. Kristalloszillator nach Anspruch 1, wobei das Kristallstück ein AT-CUT-Stück ist, wobei die X-Achsenrichtung dessen Kristallachsen (XY'Z') längs der langen Kanten und die Z'-Achsenrichtung längs der kurzen Kanten verläuft.

4. Kristalloszillator nach Anspruch 3, wobei die Z'-Ebene des Kristallstücks, die die Seitenflächen in der Längsrichtung ausbildet, welche die Z'-Achse schneiden, unter einem Winkel von θ Grad von der Y'-Achse in Richtung der Z'-Achse geneigt ist.

5. Kristalloszillator nach Anspruch 4, wobei die θ Grad 5 Grad sind.

6. Kristalloszillator nach Anspruch 1, wobei der hohle Behälter kugelförmig ist und wobei die Dicke jeder der Langkantenendflächen, die zwei Endseiten in der Kurzkantenrichtung des Kristallstücks bilden, so ist, dass die zwei Eckenbereiche jeder der Kurzkanten die Dicke von zwei Eckenbereichen von jeder der Langkantenendflächen definieren, die fortschreitend zum Mittelpunkt des äußeren Umfangs der Langkante ansteigt.

7. Kristalloszillator nach Anspruch 1, wobei das Frequenzband des Kristallstücks im 4-MHz Band liegt und die externen Draufsichtdimensionen des Kristallstücks 5,25 x 1,80 mm betragen.

8. Kristalloszillator nach Anspruch 1, wobei der flachere Teilbereich eine Region innerhalb von 1 µm von der maximalen Dicke des Kristallstücks ist und wobei jede der Tiefen D1 und D2 die Differenz zwischen der Oberfläche 1 µm einwärts von den führenden Kanten der zwei Endbereiche in der Langkantenrichtung und deren Teilbereich maximaler Dicke sind.

## Revendications

1. Oscillateur à cristal formé d'une pièce de cristal de coupe AT ayant une forme rectangulaire en vue en plan avec des grands bords et des petits bords ; une portion inclinée est prévue sur la périphérie externe entière de chacun de deux côtés de surface principale desdites pièces de cristal où ladite portion inclinée est formée lorsqu'un grand nombre desdites pièces de cristal est placé au sein d'un contenant creux ayant une périphérie interne incurvée et que ladite pièce de cristal est meulée le long de la périphérie interne dudit contenant creux à mesure que ledit contenant creux est mis en rotation ; une région centrale de ladite pièce de cristal est une portion plus plate ; où le rapport de longueur de portion plus plate L2/L1 entre la longueur L1 dans la direction de grands bords de ladite pièce de cristal sur la longueur L2 de ladite portion plus plate est compris entre 0,24 et 0,33, et également le rapport de profondeur de biseau de grands bords D1/T1 entre l'épaisseur T1 de ladite pièce de cristal et la profondeur D1 à partir de chacune des deux surfaces principales au centre de la périphérie externe de ladite portion inclinée au niveau de chacune des deux portions d'extrémité dans ladite direction de grands bords est compris entre 0,30 et 0,38, et où le rapport de largeur de portion plus plate W2/W1 entre la largeur W1 de ladite pièce de cristal dans ladite direction de grands bords et la largeur W2 de ladite portion plus plate est compris entre 0,25 et 0,55, et également le rapport de profondeur de biseau de petits bords D2/T1 entre l'épaisseur T1 de ladite pièce de cristal et la profondeur D2 au centre de la périphérie externe de ladite portion inclinée au niveau de chacune des deux portions d'extrémité de celui-ci dans la direction de petits bords est compris entre 0,08 et 0,14.

2. Oscillateur à cristal selon la revendication 1, dans lequel une électrode d'excitation formée sur chacune des deux surfaces principales de la pièce de cristal s'étend partiellement sur ladite portion inclinée depuis ladite portion plus plate.

3. Oscillateur à cristal selon la revendication 1, dans lequel ladite pièce de cristal est une pièce de coupe AT, la direction d'axe X des axes cristallins (XY'Z') de celle-ci étant le long desdits grands bords et ladite direction d'axe Z' étant le long desdits petits bords.

4. Oscillateur à cristal selon la revendication 3, dans lequel le plan Z' de ladite pièce de cristal qui forme les surfaces latérales dans la direction de la longueur qui coupent ledit axe Z' est incliné d'un angle de θ degré par rapport audit axe Y' dans ladite direction d'axe Z'.

5. Oscillateur à cristal selon la revendication 4, dans lequel ledit θ degré est 5 degrés.

6. Oscillateur à cristal selon la revendication 1, dans lequel ledit contenant creux est de forme sphérique ; et l'épaisseur de chacune des surfaces d'extrémité de grands bords qui forment deux côtés latéraux dans la direction de petits bords de ladite pièce de cristal est telle que les deux portions de coin de chacun desdits petits bords définissent l'épaisseur des deux portions de coin de chacune desdites surfaces d'extrémité de grands bords, qui augmente progressivement vers le centre de la périphérie externe dudit grand bord.

7. Oscillateur à cristal selon la revendication 1, dans lequel la bande de fréquence de ladite pièce de cristal est la bande de 4 MHz et les dimensions externes en vue en plan de ladite pièce de cristal sont de 5,25 x 1,80 mm.

8. Oscillateur à cristal selon la revendication 1, dans lequel ladite portion plus plate est une région dans l'intervalle de 1 µm par rapport à l'épaisseur maximale de ladite pièce de cristal ; et chacune desdites profondeurs D1 et D2 est la différence entre la surface à 1 µm à l'intérieur des bords d'attaque des deux portions d'extrémité dans la direction de grands bords et la portion d'épaisseur maximale de celles-ci.
